# EUROPEAN PATENT APPLICATION

(11) **EP 3 280 082 A1**
(43) Date of publication of application: **07.02.2018**
(21) Application number: 17176828.6
(22) Date of filing: 20.06.2017
(51) Int. Cl.: H04L 1/00, H04L 1/18

(54) **APPARATUS AND METHOD FOR DATA TRANSMISSION USING INCREMENTAL REDUNDANCY OR SERIALLY CONCATENATED CODES WITH DIFFERENT CODE TYPES**

(30) Priority: 01.08.2016 US 201662369251 P
(71) Applicant: MediaTek Inc., Hsin-chu City 300 (TW)
(72) Inventor: Lo, Chiaming, Tustin, CA California 92782 (US)
(74) Representative: Hoffmann Eitle

(57) **Abstract**

Aspects of the disclosure provide a source device that includes a first encoder and a second encoder. The first encoder is configured to generate an encoded message by encoding an original message using a fixed-length code that has a fixed code rate. The second encoder is configured to generate a parity code by encoding the encoded message using a variable-length code that has an adjustable code rate set based on a requested code rate. Aspects of the disclosure further provide a destination device that includes a mixer and a decoder. The mixer is configured to generate a reconstructed message by decoding an incoming message and a parity code using a variable-length code that has an adjustable code rate. The decoder is configured to decode the reconstructed message using a fixed-length code that has a fixed code rate.

## Description

### INCORPORATION BY REFERENCE

This present disclosure claims the benefit of U.S. Provisional Application No. 62/369,251, "Efficient Method for Block Codes with IR-Like Combining and Coding Scheme" filed on August 1, 2016, which is incorporated herein by reference in its entirety.

### BACKGROUND

The background description provided herein is for the purpose of generally presenting the context of the disclosure. Work of the presently named inventors, to the extent the work is described in this background section, as well as aspects of the description that may not otherwise qualify as prior art at the time of filing, are neither expressly nor impliedly admitted as prior art against the present disclosure.

In many communication systems, data transmission from a source device to a destination device may include encoding an original message using a predetermined error correction code at the source device, transmitting the encoded message from the source device to the destination device through a communication channel, and decoding the received encoded message using the predetermined error correction code at the destination device in order to retrieve the original message. When the transmission of the encoded message is insufficient for extracting the original message at the destination device, such as when the received encoded message is not decodable or the decoded message includes an excessive number of errors, the destination device may request the source device to re-transmit the encoded message and/or to send additional error correction information. In some applications, the combination of error correction coding and a re-transmission mechanism can be referred to as a hybrid automatic repeat request (HARQ) technique.

### SUMMARY

Aspects of the disclosure provide a source device that includes a first encoder, a second encoder, and a transceiver. The first encoder is configured to generate an encoded message by encoding an original message using a fixed-length code that has a fixed code rate. The second encoder is configured to generate a parity code by encoding the encoded message using a variable-length code that has an adjustable code rate. The transceiver is configured to transmit the encoded message during a first transmission, receive a re-transmission request indicating that the first transmission is insufficient for extracting the original message, and transmit the parity code during a second transmission in response to receiving the re-transmission request.

In an embodiment, the transceiver is configured to transmit the encoded message without transmitting the parity code during the first transmission, and transmit the parity code without transmitting the encoded message during the second transmission.

The second encoder may be further configured to generate a second parity code by encoding the encoded message using the variable-length code. The transceiver may be further configured to receive a second re-transmission request indicating that the first and second transmissions are insufficient for extracting the original message, and transmit the second parity code during a third transmission in response to receiving the second re-transmission request. The parity code and the second parity code may correspond to different code rates or different parity punctuation settings.

The fixed-length code may use a low-density parity-check (LDPC) code, a polar code, a Hamming code, a Reed-Solomon code, or a Hadamard code. Also, the variable-length code may use a convolutional code or a turbo code

Aspects of the disclosure further provide a destination device that includes a mixer, a decoder, and a transceiver. The mixer is configured to generate a reconstructed message by decoding an incoming message and a parity code using a variable-length code that has an adjustable code rate. The decoder is configured to decode the incoming message using a fixed-length code that has a fixed code rate, and decode the reconstructed message using the fixed-length code. The transceiver is configured to receive the incoming message during a first transmission, transmit a first re-transmission request indicating that the first transmission is insufficient for extracting an original message, and receive the parity code that is transmitted during a second transmission in response to the first re-transmission request.

The transceiver may be further configured to transmit a second re-transmission request indicating that the first and second transmissions are insufficient for extracting the original message, and receive a second parity code that is transmitted in response to the second re-transmission request. The mixer may be further configured to generate a second reconstructed message by decoding at least the incoming message and the second parity code using the variable-length code. Also, the decoder may be further configured to decode the second reconstructed message using the fixed-length code.

In an embodiment, the variable-length code includes iterations of plural stages of decoding processes. The reconstructed message may be generated by performing equal to or less than one full iteration of the plural stages of decoding processes.

Aspects of the disclosure further provide a source device that includes a first encoder, a second encoder, and a transceiver. The first encoder is configured to generate an encoded message by encoding an original message using a fixed-length code that has a fixed code rate. The second encoder is configured to generate a parity code by encoding the encoded message using a variable-length code that has an adjustable code rate set based on a requested code rate. The transceiver configured to transmit the encoded message together with the parity code.

Aspects of the disclosure further provide a destination device that includes a mixer, a decoder, and a transceiver. The transceiver is configured to receive an incoming message together with a parity code. The mixer is configured to generate a reconstructed message by decoding the incoming message and the parity code using a variable-length code that has an adjustable code rate. The decoder is configured to decode the reconstructed message using a fixed-length code that has a fixed code rate.

In an embodiment, the variable-length code includes iterations of plural stages of decoding processes. The reconstructed message may be generated by performing equal to or less than one full iteration of the plural stages of decoding processes.

### BRIEF DESCRIPTION OF THE DRAWINGS

Various embodiments of this disclosure that are proposed as examples will be described in detail with reference to the following figures, wherein like numerals reference like elements, and wherein:
Fig. 1 shows an exemplary functional block diagram of a source device and a destination device for illustrating data transmission therebetween according to an embodiment of the disclosure;
Figs. 2A-2B show exemplary diagrams of data arrangement schemes for encoding and decoding messages by the source device and the destination device in Fig. 1, respectively, based on a coded-combining method according to an embodiment of the disclosure;
Fig. 3A shows a graph of signal-to-noise ratios (SNR) versus block error rate (BLER) illustrating simulation results of different combining methods according to an embodiment of the disclosure;
Fig. 3B shows a graph of code rates (CR) versus SNR illustrating simulation results of different combining methods under a given BLER condition according to an embodiment of the disclosure;
Fig. 4A shows an exemplary diagram of a data arrangement scheme for encoding and decoding messages by the source device and the destination device in Fig. 1, respectively, based on a hybrid-coding method according to an embodiment of the disclosure;
Figs. 4B-4C show exemplary diagrams of data arrangement schemes for encoding messages by the source device in Fig. 1 based on a hybrid-coding method according to an embodiment of the disclosure;
Fig. 5A shows a graph of SNR versus BLER illustrating simulation results of different coding methods according to an embodiment of the disclosure;
Fig. 5B shows a graph of CR versus SNR illustrating simulation results of different coding methods under a given BLER condition according to an embodiment of the disclosure;
Fig. 6A shows an exemplary block diagram of a source device according to an embodiment of the disclosure;
Fig. 6B shows an exemplary block diagram of a destination device according to an embodiment of the disclosure;
Fig. 7 shows a flow chart outlining an exemplary process for encoding and transmitting messages using a coded-combining method according to an embodiment of the disclosure;
Fig. 8 shows a flow chart outlining an exemplary process for receiving and decoding messages using a coded-combining method according to an embodiment of the disclosure;
Fig. 9 shows a flow chart outlining an exemplary process for encoding and transmitting messages using a hybrid-coding method according to an embodiment of the disclosure; and
Fig. 10 shows a flow chart outlining an exemplary process for receiving and decoding messages using a hybrid-coding method according to an embodiment of the disclosure.

### DETAILED DESCRIPTION OF EMBODIMENTS

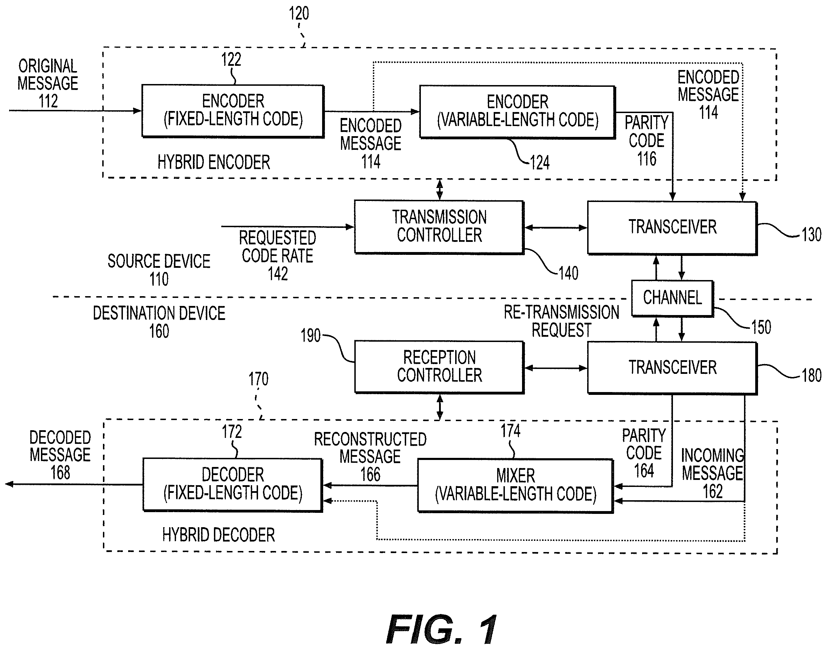

Fig. 1 shows an exemplary functional block diagram of a source device 110 and a destination device 160 for illustrating data transmission therebetween via a transmission channel 150 according to an embodiment of the disclosure. The source device 110 or the destination device 160 may be a computational device, a portable device, a wearable device, a smart appliance, or the like. In some examples, a single device may be configured to function as both the source device 110 and the destination device 160.

During operation, the source device 110 can receive an original message 112, generate an encoded message 114 by encoding the original message 112, generate a parity code 116 by encoding the encoded message 112, and transmit the encoded message 114 and/or the parity code 116 to the destination device 160 via the communication channel 150. The destination device 160 can receive an incoming message 162 and an incoming parity code 164 that correspond to the encoded message 114 and the parity code 116 from the source device 110. The incoming message 162 and incoming parity code 164 can be subject to distortions and/or interferences caused by the communication channel 150. The destination device 160 can generate a reconstructed message 166 based on the incoming message 162 and parity code 164 and decode the incoming message 162 or the reconstructed message 166 to generate a decoded message 168.

In some examples, the source device 110 and the destination device 160 may communicate through the communication channel using a predetermined wired or wireless communication protocol, which may be compatible with the physical layer of one or more standards. Example communication standards include Global System for Mobile communications (GSM), General Packet Radio Service (GPRS) technology, Enhanced Data rates for Global Evolution (EDGE) technology, Universal Mobile Telecommunications System (UMTS), Worldwide Interoperability for Microwave Access (WiMAX) technology, and Long Term Evolution (LTE) technology, and the like.

As shown, the source device 110 includes a hybrid encoder 120, a transceiver 130, and a transmission controller 140. The hybrid encoder 120 includes a first encoder 122 and a second encoder 124. The first encoder 122 may receive the original message 112 and generate the encoded message 114 by encoding the original message 112 using a fixed-length code that has a fixed code length and/or a fixed code rate. The encoded message 114 may include an information portion that corresponds to the original message 112 and a parity portion that includes redundancy information for error detection and/or correction process to be performed at the receiving end, such as the destination device 160. The encoded message 114 may be forwarded to the transceiver 130 directly from the first encoder 122 or via the second encoder 124.

The second encoder 124 may generate the parity code 116 by encoding the encoded message 114 using a variable-length code that has an adjustable code length and/or an adjustable code rate. The second encoder 124 may output a twice-encoded message that includes an information portion corresponding to the encoded message 114 and/or a parity portion (i.e., the parity code 116) that includes redundancy information for error detection and/or correction process to be performed at the receiving end, such as the destination device 160. In some examples, the second encoder 124 may only output the parity code 116, and the encoded message 114 may be output to the transceiver 130 from the first encoder 122.

The transceiver 130 can modulate the encoded message 114 and/or the parity code 116 and transmit the modulated signal to the destination device 160 through the communication channel 150. The transceiver 130 can also receive signals from the destination device 160 and demodulate the received signal to extract therefrom transmission control messages, such a re-transmission request. The controller 140 may configure and control the operations of the hybrid encoder 120 and the transceiver 130 based on information, such as a requested code rate 142 and/or the re-transmission request extracted by the transceiver 130. In some examples, the controller 140 may start a timer after each transmission and transmit the same information again and/or additional error correction information when the re-transmission request is received before the timer expires.

The fixed-length code used by the encoder 122 and/or decoder 172 may correspond to an encoding and decoding scheme that can be implemented based on any given code length and code rate in theory, but the implementation thereof, especially at the decoding stage, may need to be individually tailored for each code length or code rate. Therefore, the processing complexity for implementing an encoder and/or decoder using the fixed-length code increases significantly with the number of the code lengths and/or code rates to be covered. The fixed-length code may correspond to a block code based encoding/decoding method. In some examples, the fixed-length code may use a low-density parity-check (LDPC) code, a polar code, a Hamming code, a Reed-Solomon code, or a Hadamard code.

The variable-length code may correspond to an encoding and decoding scheme that the processing complexity thereof remains the same or only increases insignificantly with the number of the code lengths and/or code rates to be covered. The variable-length code may correspond to a convolutional code based encoding/decoding method. In some examples, the variable-length code may use a convolutional code or a turbo code.

In operation, the source device 110 may be used to implement the encoding stage of a coded-combining method, where the encoded message 114 is transmitted to the destination device 160 during a first transmission. When a re-transmission request is received because the first transmission is insufficient for the destination device 160 to extract the original message, the source device 110 may further transmit the parity code 116 during a second transmission. In addition, when a second re-transmission request is received because the first and second transmissions are insufficient for the destination device 160 to extract the original message, the source device 110 may further transmit a second parity code during a third transmission. The second parity code may be generated by encoding the encoded message 114 using the variable-length code, and the parity code and the second parity code may correspond to different code rates or different parity punctuation settings.

In addition, the source device 110 may also be used to implement the encoding stage of a hybrid-coding method, where the parity code 116 is generated based on a requested code rate 142, and the encoded message 114 and the parity code 116 are transmitted to the destination device 160 during a first transmission. When the first transmission is insufficient for the destination device 160 to extract the original message, the source device 110 may re-transmit the same encoded message 114 and/or parity code 116, the encoded message 114 together with a newly generated parity code based on a different requested code rate, or only the newly generated parity code in a manner similar to the coded-combining method illustrated above.

The destination device 160 includes a hybrid decoder 170, a transceiver 180, and a reception controller 190. The hybrid decoder 170 includes a decoder 172 and a mixer 174. The mixer 174 may receive the incoming message 162 and the parity code 164 from the transceiver 180, and generate a reconstructed message 166 by decoding the incoming message 162 and the parity code 164 using a variable-length code that has an adjustable code length and/or an adjustable code rate. In some example, the variable-length code used by the mixer 174 of the destination device 160 and the variable-length code used by the second encoder 124 of the corresponding source device 110 correspond to decoding and encoding aspects of the same variable-length code, respectively. In some examples, the decoding aspect of the variable-length code may include iterations of plural stages of decoding processes, and the reconstructed message 166 may be generated by performing only one full iteration of the plural stages of decoding processes or less than one full iteration of the plural stages of decoding processes. For example, when the variable-length code is a turbo code that includes two cascaded decoding processes at the decoding stage, the mixer 174 may be implemented to perform only a first half of one full iteration, i.e., only executing the first decoding process of the two cascaded decoding processes once.

The decoder 172 may generate the decoded message 168 by decoding the incoming message 162 or the reconstructed message 166 using a fixed-length code that has a fixed code length and/or a fixed code rate. In some example, the fixed-length code used by the decoder 172 of the destination device 160 and the fixed-length code used by the first encoder 122 of the corresponding source device 110 correspond to decoding and encoding aspects of the same fixed-length code, respectively.

Moreover, the transceiver 180 can receive modulated signal from the source device 110 through the communication channel 150 and demodulate the received signals to retrieve the incoming message 162 and/or the parity code 164. The transceiver 180 can also modulate transmission control messages, such as a re-transmission request, and transmit the modulated signals to the source device 110. The controller 190 may configure and control the operations of the hybrid decoder 170 and the transceiver 180 based on status of the incoming message 162, parity code 164, reconstructed message 166, and/or the decoded message 168.

In operation, the destination device 160 may be used to implement the decoding stage of a coded-combining method. The incoming message 162 from the source device 110 may be received during a first transmission and forwarded to the decoder 172, either directly from the transceiver 180 or indirectly through the mixer 174. The decoder 172 may generate the decoded message 168 by decoding the incoming message 162. When the incoming message 162 cannot be decoded or the decoded message 168 includes more than a predetermined number of errors, the decoder 172 may inform the reception controller 190 that the first transmission is insufficient for extracting a corresponding original message. The reception controller 190 may instruct the transceiver 180 to transmit a re-transmission request to the source device 110. In some examples, in response to the re-transmission request, the source device 110 may transmit a parity code 164 to the destination device 160 during a second transmission. After the transceiver 180 receives the parity code 164, the mixer 174 generates the reconstructed message 166 by decoding the incoming message 162 and the parity code 164. The decoder 172 may again generate a second decoded message by decoding the reconstructed message 166.

Moreover, when the reconstructed message 166 cannot be decoded or the second decoded message includes more than the predetermined number of errors, the decoder 172 may inform the reception controller 190 that the first and second transmissions are insufficient for extracting the corresponding original message. The reception controller 190 may instruct the transceiver 180 to transmit a second re-transmission request to the source device 110. In some examples, in response to the second re-transmission request, the source device 110 may transmit a second parity code to the destination device 160 during a third transmission. After the transceiver 180 receives the second parity code, the mixer 174 generates a second reconstructed message 166 by decoding the incoming message 162 and the second parity code. In some examples, the mixer 174 may generate the second reconstructed message 166 by decoding the incoming message 162 and a combination of the parity code 164 and the second parity code. The decoder 172 may again generate a third decoded message by decoding the second reconstructed message.

In addition, the destination device 110 may also be used to implement the decoding stage of a hybrid-coding method, where the transceiver 180 may receive the incoming message 162 and the parity code 164 that correspond to the encoded message 114 and the parity code 116, respectively, during the same transmission. The mixer 174 may generate the reconstructed message 166 based on the incoming message 162 and the parity code 164. The decoder 172 may generate the decoded message 168 by decoding the reconstructed message 166. When the transmission is insufficient for extracting a corresponding original message, the reception controller 190 may request the source device 110 to transmit the same encoded message 114 and/or parity code 116, the encoded message 114 together with a newly generated parity code based on a different requested code rate, or just the newly generated parity code in a manner similar to the coded-combining method illustrated above.

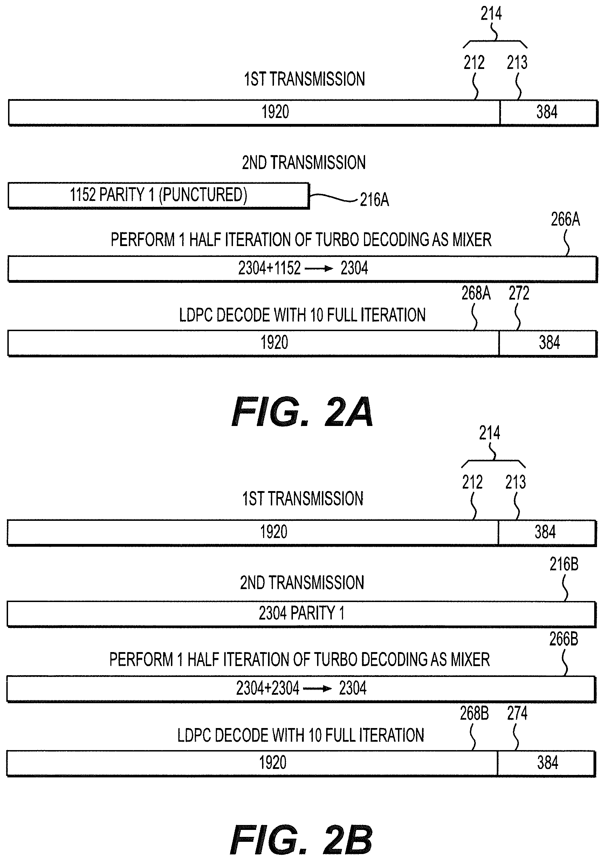

Fig. 2A shows an exemplary diagram of a data arrangement scheme for encoding and decoding messages by a source device and a corresponding destination device, respectively, based on a coded-combining method according to an embodiment of the disclosure. In some examples, the source device and the corresponding destination device may correspond to the source device 110 and the destination device 160 in Fig. 1.

In this example, the first encoder 122 of the source device 110 and the decoder 172 of the destination device 160 can encode or decode messages using an LDPC code, and the second encoder 124 of the source device 110 and the mixer 174 of the destination device 160 can encode or at least partially decode messages using a turbo code.

As shown in Fig. 2A, data block 214 may correspond to the encoded message 114, data block 216A may correspond to the parity code 116, data block 266A may correspond to the reconstructed message 166, and data block 268A may correspond to the decoded message 168. The data block 214 includes data block 212 and data block 213. The data block 212 may correspond to the original message 112 or the information portion of the encoded message 114. The data block 213 may correspond to the parity portion of the encoded message 114. Also, the data block 272 may correspond to a parity portion that accompanies the decoded message 168 during the decoding process.

In an example, the original message 112 (data block 212) may include 1920 information bits. The encoder 122 may generate the parity portion (data block 213) of the encoded message 114 (data block 214) using the LDPC code. During a first transmission, the transceiver 130 transmits the encoded message 114 (data block 214) to the destination device 160. If there is no re-transmission request form the destination device 160 within a predetermined waiting period, the source device 110 may assume that the destination device 160 can successfully decode the encoded message 114 and the transmission of the original message 112 is completed. However, a second transmission may be performed in response to a re-transmission request form the destination device 160 received within the predetermined waiting period. In such scenario, the encoder 124 may further generate the parity code 116 (data block 216A) using the turbo code. In some example, the parity code 116 (data block 216A) includes 1153 bits and may correspond to punctuated first parity code (e.g., non-interleaved parity code) of turbo coding.

After the destination device 160 receives the incoming message 163 from the first transmission and the incoming parity code 164 from the second transmission, the mixer 174 of the destination device 160 may generate the reconstructed message 166 (data block 266A, 2304 bits) by decoding the combination of the incoming message 163 and the parity code 164 (2304+1152 bits). The combination of the first transmission and the second transmission thus has an equivalent code rate of 1920/3456 or about 0.56. In some examples, the mixer 174 is a turbo code decoder or a partially implemented turbo code decoder that may only perform one half iteration of the turbo decoding process. The mixer 174 may be a fully operational turbo code decoder that is also usable a turbo code decoder for other data processing tasks. Of course, in some examples, the reconstructed message 166 may be generated by performing more than one full iteration of the turbo decoding process at the expense of additional computational latency.

Finally, the decoder 172 may decode the reconstructed message 166 (data block 266A) by performing an LDPC decoding process with a predetermined number of full iterations, such as 10 full iterations. As a result, the decoder 172 may generate the decoded message 168 (data block 268A) that also has 1920 bits, accompanied by a corresponding parity portion (data block 272) used and updated throughout the decoding process.

Fig. 2B shows an exemplary diagram of another data arrangement scheme for encoding and decoding messages by a source device and a corresponding destination device, respectively, based on a coded-combining method according to an embodiment of the disclosure. In some examples, the source device and the corresponding destination device may correspond to the source device 110 and the destination device 160 in Fig. 1.

Similar to the example according to Fig. 2A, in the example according to Fig. 2B, the first encoder 122 of the source device 110 and the decoder 172 of the destination device 160 can encode or decode messages using an LDPC code, and the second encoder 124 of the source device 110 and the mixer 174 of the destination device 160 can encode or at least partially decode messages using a turbo code. Also, data block 214 may correspond to the encoded message 114, data block 212 may correspond to the original message 112 or the information portion of the encoded message 114, and data block 213 may correspond to the parity portion of the encoded message 114.

Moreover, data block 216B may correspond to the parity code 116, data block 266B may correspond to the reconstructed message 166, and data block 268B may correspond to the decoded message 168. Data block 274 may correspond to a parity portion that accompanies the decoded message 168 during the decoding process.

Compared with the example according to Fig. 2A, the parity code (data block 216B) in the example according to Fig. 2B includes 2304 bits and may correspond to the first parity code of turbo coding. After the destination device 160 receives the incoming message 163 and the incoming parity code 164, the mixer 174 of the destination device 160 may generate the reconstructed message 166 (data block 266B, 2304 bits) by decoding the combination of the incoming message 163 and the parity code 164 (2304+2304 bits). The combination of the first transmission and the second transmission thus has an equivalent code rate of 1920/4608 or about 0.42. The mixer 174 may be a turbo code decoder or a partially implemented turbo code decoder that may only perform one half iteration of the turbo decoding process. Finally, the decoder 172 may decode the reconstructed message 166 (data block 266B) by performing an LDPC decoding process with 10 full iterations. As a result, the decoder 172 may generate the decoded message 168 (data block 268B) that also has 1920 bits, accompanied by a corresponding parity portion (data block 274) used and updated throughout the decoding process.

In some examples, the parity code represented by the data block 216B in Fig. 2B may be used for another transmission subsequent to the second transmission in the example according to Fig. 2A when the sources device 110 receives another re-transmission request from the destination device 160 that indicates the first and second transmissions in Fig. 2A are insufficient for extracting a corresponding original message.

As shown in Figs. 2A and 2B, the equivalent code rate for encoding the original message 112 (data block 212) may be adjusted by including different parity codes 116 using a variable-length code (e.g., a turbo code) in addition to encoding or decoding the original message 112 using a fixed-length code (e.g., an LDPC code) with a fixed code rate (e.g., 1920/2304 or about 0.83). The re-transmission or the transmission of additional parity information may be implemented in an incremental manner using the variable-length code. Also, the equivalent code rate may be easily adjusted by adjusting the generation of the additional parity code without increasing the processing complexity of the first encoder 122 or decoder 172.

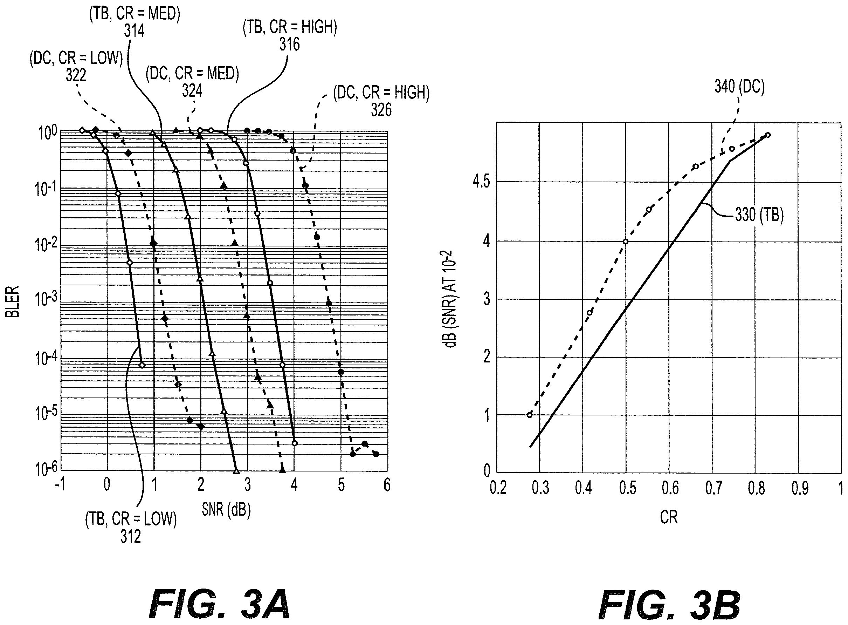

Fig. 3A shows a graph of signal-to-noise ratios (SNR) versus block error rate (BLER) illustrating simulation results of different combining methods according to an embodiment of the disclosure.

Curve 312 corresponds to a coded-combining method using turbo decoder as a mixer (also referred to as "turbo combining") for combining an initial incoming message and a subsequently received parity code and having a lower code rate, such as 1920/6912. Curve 314 corresponds to turbo combining and having a medium code rate, such as 1920/4608. Curve 316 corresponds to turbo combining and having a higher code rate, such as 1920/3456. In addition, curve 322 corresponds to using chase combining for combining an initial incoming message and a subsequently received parity code and having a lower code rate, such as 1920/6912. Curve 324 corresponds to chase combining and having a medium code rate, such as 1920/4608. Curve 326 corresponds to chase combining and having a higher code rate, such as 1920/3456.

As shown in Fig. 3A, when the data transmission is performed under a similar SNR condition, using turbo combining would have a lower BLER than using chase combining. Therefore, turbo combining may be more efficient than chase combining in generating a reconstructed message for a further fixed-length decoding process.

Fig. 3B shows a graph of code rates (CR) versus SNR illustrating simulation results of different combining methods under a given BLER condition according to an embodiment of the disclosure.

Curve 330 corresponds to using turbo combining with a target BLER of 10⁻² dB. Curve 340 corresponds to using chase combining with the same target BLER of 10⁻² dB. As shown in Fig. 3B, to achieve the same target BLER using similar code rates, using turbo combining would have a lower SNR requirement than using chase combining. Therefore, under similar operational conditions, using turbo combining would outperform using chase combining by 1 dB with respect to the SNR.

Therefore, turbo combining may provide improved performance than chase combining at the expense of using a turbo code encoder at the encoding stage and using a turbo decoder as a mixer at the decoding stage. Nevertheless, in some examples, turbo code encoder and/or turbo code decoder for turbo combining may reuse the turbo code encoder and/or turbo code decoder that has been implemented in the source or destination device for data processing based on other communication standards, such as the Universal Mobile Telecommunication System (UMTS) standard and the Long Term Evolution (LTE) standard. Accordingly, implementing the turbo combining in a device in some applications may only require insignificant modification to the hardware and/or software that are already part of the device.

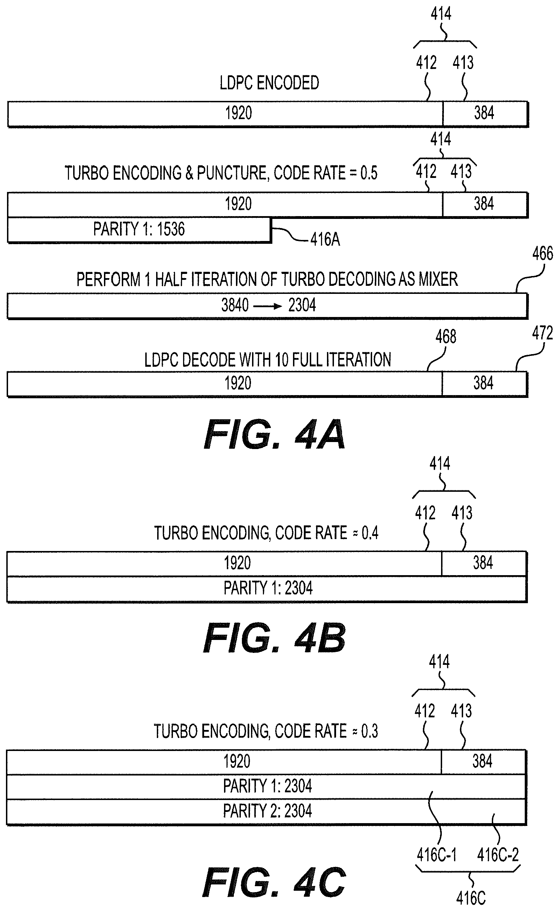

Fig. 4A shows an exemplary diagram of a data arrangement scheme for encoding and decoding messages by a source device and a corresponding destination device, respectively, based on a hybrid-coding method according to an embodiment of the disclosure. In some examples, the source device and the corresponding destination device may correspond to the source device 110 and the destination device 160 in Fig. 1.

Similar to the examples in Figs. 2A-3B, in this example, the first encoder 122 of the source device 110 and the decoder 172 of the destination device 160 can encode or decode messages using an LDPC code, and the second encoder 124 of the source device 110 and the mixer 174 of the destination device 160 can encode or at least partially decode messages using a turbo code.

As shown in Fig. 4A, data block 414 may correspond to the encoded message 114, data block 416A may correspond to the parity code 116, data block 466 may correspond to the reconstructed message 166, and data block 468 may correspond to the decoded message 168. The data block 414 includes data block 412 and data block 413. The data block 412 may correspond to the original message 112 or the information portion of the encoded message 114. The data block 413 may correspond to the parity portion of the encoded message 114. Also, the data block 472 corresponds to a parity portion that accompanies the decoded message 168 during the decoding process.

The original message 112 (data block 412) may include 1920 information bits. The encoder 122 may generate the parity portion (data block 413) of the encoded message 114 (data block 414) using the LDPC code. The encoder 124 may further generate the parity code 116 (data block 416A) by further encoding the encoded message using the turbo code. The parity code 116 (data block 416A) may include 1536 bits and may be punctuated first parity code (e.g., non-interleaved parity code) of turbo coding. The transceiver 130 may transmit the encoded message 114 (data block 414) together with the parity code 116 (data block 416A) to the destination device 160. The original message 112 (data block 412) thus may be transmitted at an equivalent code rate of 1920/3840 or 0.5.

After the destination device 160 receives the incoming message 163 and the incoming parity code 164 that corresponds to the encoded message 114 (data block 414) and the parity code 116 (data block 416A), the mixer 174 of the destination device 160 may generate the reconstructed message 166 (data block 466, 2304 bits) by at least partially decoding the combination of the incoming message 163 and the parity code 164 (2304+1536 bits). In some examples, the mixer 174 is a turbo code decoder or a partially implemented turbo code decoder that may only perform one half iteration of the turbo decoding process. Finally, the decoder 172 may decode the reconstructed message 166 (data block 466) by performing an LDPC decoding process with a predetermined number of full iterations, such as 10 full iterations. As a result, the decoder 172 may generate the decoded message 168 (data block 468) that also has 1920 bits, accompanied by a corresponding parity portion (data block 472) used and updated throughout the decoding process.

Fig. 4B show an exemplary diagram of another data arrangement schemes for encoding messages by a source device, such as the source device 110 in Fig. 1, based on a hybrid-coding method according to an embodiment of the disclosure. The data blocks in Fig. 4B that are the same or similar to those in Fig. 4A are given the same reference numbers, and detailed description thereof is thus omitted.

Compared with the example in Fig. 4A, the encoder 124 may generate the parity code 116 (data block 416B) using the turbo code, where the parity code 116 (data block 416B) includes 2304 bits and may be first parity code of turbo coding without punctuation. The transceiver 130 may transmit the encoded message 114 (data block 414) together with the parity code 116 (data block 416B) to the destination device 160. The original message 112 (data block 412) thus may be transmitted at an equivalent code rate of 1920/4608 or about 0.4.

Similar to the example in Fig. 4A, after the destination device 160 receives the incoming message 163 and the incoming parity code 164 that corresponds to the encoded message 114 (data block 414) and the parity code 116 (data block 416B), the mixer 174 of the destination device 160 may generate the reconstructed message 166 by at least partially decoding the combination of the incoming message 163 and the parity code 164 (2304+2304 bits). Finally, the decoder 172 may decode the reconstructed message 166 by performing an LDPC decoding process with 10 full iterations.

Fig. 4C show an exemplary diagram of yet another data arrangement schemes for encoding messages by a source device, such as the source device 110 in Fig. 1, based on a hybrid-coding method according to an embodiment of the disclosure. The data blocks in Fig. 4C that are the same or similar to those in Fig. 4A are given the same reference numbers, and detailed description thereof is thus omitted.

Compared with the example in Fig. 4A, the encoder 124 may generate the parity code 116 (data block 416C) using the turbo code, where the parity code 116 (data block 416C) includes a first portion 416C-1 and a second portion 416C-2. The first portion 416C-1 may have 2304 bits and may be first parity code of turbo coding without punctuation. The second portion 416C-2 may have 2304 bits and may be second parity code (e.g., interleaved parity code) of turbo coding. The transceiver 130 may transmit the encoded message 114 (data block 414) together with the parity code 116 (data block 416C) to the destination device 160. The original message 112 (data block 412) thus may be transmitted at an equivalent code rate of 1920/6912 or about 0.3.

Similar to the example in Fig. 4A, after the destination device 160 receives the incoming message 163 and the incoming parity code 164 that corresponds to the encoded message 114 (data block 414) and the parity code 116 (data block 416C), the mixer 174 of the destination device 160 may generate the reconstructed message 166 by at least partially decoding the combination of the incoming message 163 and the parity code 164 (2304+4608 bits). Compared with the examples in Fig. 4A and 4B, because the parity code 116 (data block 416C) includes both the first parity code and the second parity code of turbo coding, the reconstructed message 166 may be generated by performing at least one full iteration of turbo decoding process. Finally, the decoder 172 may decode the reconstructed message 166 by performing an LDPC decoding process with 10 full iterations.

In some examples, the parity codes represented by the data block 416B and 416C may be used for subsequent incremental transmission to supplement the transmission in the example according to Fig. 4A when the sources device 110 receives re-transmission requests from the destination device 160.

As shown in Figs. 4A-4C, despite the variable equivalent code rate by including different parity codes 116, the encoding of the original message 112 may use the same encoding process, e.g., a LDPC encoder with a predetermined code rate (e.g., 1920/2304 or about 0.83). Similarly, despite the variable equivalent code rate by receiving different parity codes 164, the decoding of the incoming message 162 and/or the reconstructed message 166 may use the same decoding process, e.g., a LDPC decoder with a predetermined code rate (e.g., 1920/2304 or about 0.83) with fixed and optimized processing complexity. Therefore, the equivalent code rate may be easily adjusted by adjusting the generation of the additional parity code without increasing the processing complexity of the first encoder 122 or decoder 172.

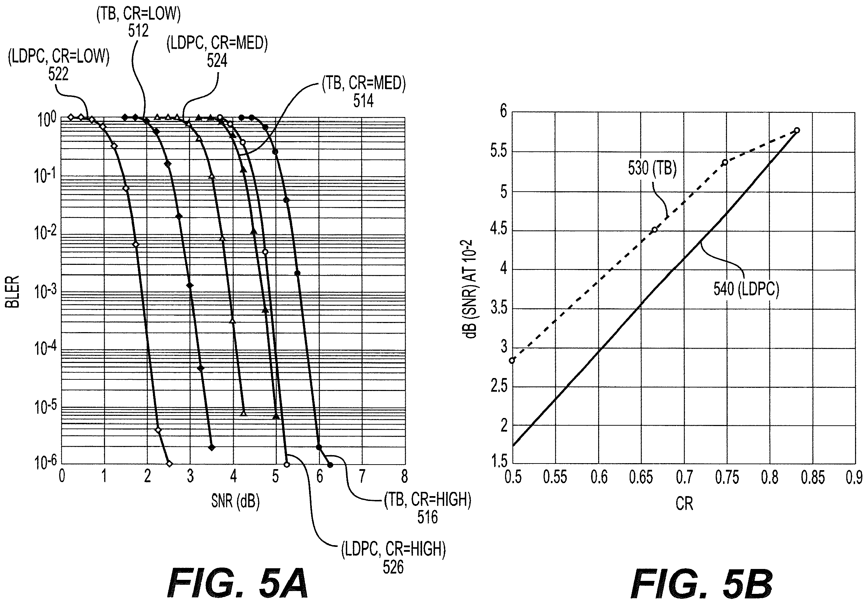

Fig. 5A shows a graph of SNR versus BLER illustrating simulation results of different coding methods according to an embodiment of the disclosure.

Curve 512 may correspond to using turbo coding to encode an LDPC-encoded message (also referred to as "turbo coded LDPC") and having a lower code rate, such as 1920/3840 or 1/2. Curve 514 may correspond to turbo coded LDPC and having a medium code rate, such as 1920/2880 or 2/3. Curve 516 may correspond to turbo coded LDPC and having a higher code rate, such as 1920/2650 or about 3/4. In addition, curve 522 may correspond to using LDPC code to encode the original message and having a lower code rate, such as 1152/2304 or 1/2. Curve 524 may correspond to LDPC coding and having a medium code rate, such as 1536/2304 or 2/3. Curve 526 may correspond to LDPC coding and having a higher code rate, such as 1728/2304 or 3/4.

As shown in Fig. 5A, when the data transmission is performed under a similar SNR condition, using turbo coded LDPC would have a higher BLER than using LDPC coding.

Fig. 5B shows a graph of CR versus SNR illustrating simulation results of different coding methods under a given BLER condition according to an embodiment of the disclosure.

Curve 500 may correspond to using turbo coded LDPC with a target BLER of 10⁻² dB. Curve 540 may correspond to using LDPC coding with the same target BLER of 10⁻² dB. As shown in Fig. 5B, to achieve similar BLER using similar code rate, using turbo coded LDPC would have a higher SNR requirement than using LDPC coding. Therefore, under similar operational conditions, using turbo coded LDPC would be inferior to using LDPC coding by about 1 dB with respect to the SNR. However, as further illustrated with reference to Table I below, using turbo coded LDPC may easily provide adjustable code rate functionality or a low code rate with much less hardware and/or software complexity than using LDPC coding.

Table I shows the hardware and/or software complexity (or simply referred to as processing complexity) of implementing various code rates using turbo coded LDPC versus the processing complexity of implementing various code rates using LDPC coding.

**TABLE I**

| | Code Rate | 1/2 | 2/3 | 3/4 | 5/6 |
|---|---|---|---|---|---|
| LDPC Coding | Complexity | 12×L×I | 8×L×I | 6×L×I | 4×L×I |
| | SNR @ 10⁻² dB | 1.7059 | 3.7345 | 6.6867 | 5.7790 |
| Turbo Coded LDPC | Complexity | 4×L×I+1×H | 4×L×I+1×H | 4×L×I+1×H | 4×L×I |
| | SNR @ 10⁻² dB | 2.8131 | 4.5098 | 5.3674 | 5.7771 |

In Table I, L represents one LDPC layered operation by a hardware unit; I represents one LDPC iteration; and H represents one-half of turbo decoding operation. As shown in Table I, when the code rate is at 5/6, the LDPC encoded message is not further encoded by turbo coding, and thus the processing complexity and SNR for LDPC coding and Turbo-coded LDPC are basically the same. When the code rate is at 1/2, 2/3, or 3/4, the SNR for LDPC coding remains about 1 dB better than the SNR for Turbo-coded LDPC. However, the processing complexity for LDPC coding increases significantly when the code rate is decreasing, while the processing complexity for Turbo-coded LDPC remains the same.

Accordingly, at the cost of about 1 dB difference in the SNR, the Turbo-coded LDPC can be implemented with consistent hardware and/or software complexity. In some examples, consistent processing complexity corresponds to consistent decoding latency despite the code rates, which could be preferable in mobile communication applications at the cost of a consistent 1 dB degradation in SNR. In some examples, various code rates may be implemented within about the same processing latency by basically the same hardware when using the turbo coded LDPC, while duplicated hardware for parallel processing would be needed when using the LDPC coding.

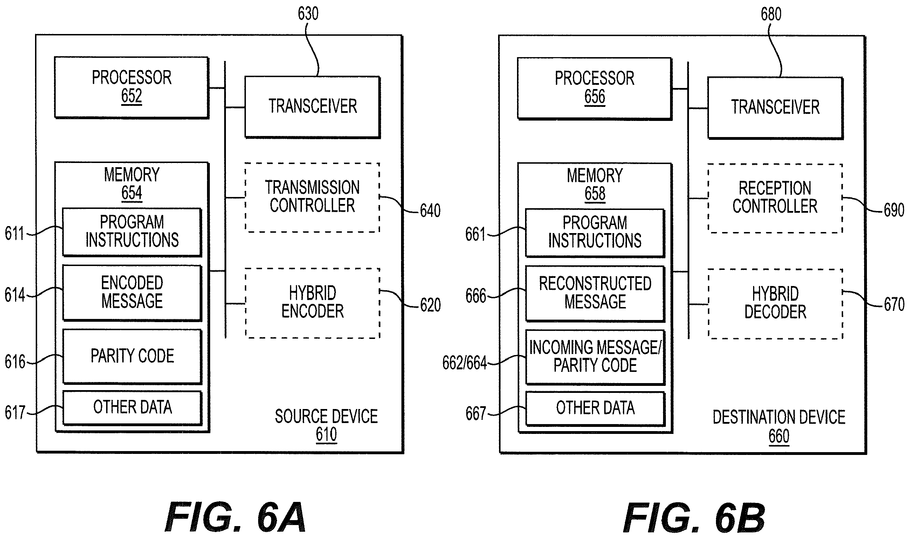

Fig. 6A shows an exemplary block diagram of a source device 610 according to an embodiment of the disclosure. In some examples, the source device 610 corresponds to the source device 110 in Fig. 1.

The source device 610 includes a hybrid encoder 620, a transceiver 630, and a transmission controller 640 that may correspond to the hybrid encoder 120, the transceiver 130, and the transmission controller 140 in Fig. 1, respectively. The source device 610 also includes a processor 652 and a memory 654.

The processor 652 can be configured to execute program instructions 611 stored in the memory 654 to perform various functions, such as the encoding and transmission functions illustrated with reference to Figs. 1-5B. The processor 652 can include a single or multiple processing cores. In some examples, the hybrid encoder 620, the transceiver 630, and/or the transmission controller 640 may be implemented by hardware components, the processor 652 executing the program instructions 611, or a combination thereof. Of course, the processor 652 can also execute program instructions 611 to perform other functions for the source device 610 that are not described in the present disclosure.

The memory 654 can be used to store the program instructions 611 and information such an encoded message 614, a parity code 616, other data 617, and/or intermediate data. In some examples, the memory 654 includes a non-transitory computer readable medium, such as a semiconductor or solid-state memory, a random access memory (RAM), a read-only memory (ROM), a hard disk, an optical disk, or other suitable storage medium. In some embodiments, the memory 654 includes a combination of two or more of the non-transitory computer readable mediums listed above.

Fig. 6B shows an exemplary block diagram of a destination device 660 according to an embodiment of the disclosure. In some examples, the destination device 660 corresponds to the destination device 160 in Fig. 1.

The destination device 660 includes a hybrid decoder 670, a transceiver 680, and a reception controller 690 that may correspond to the hybrid decoder 170, the transceiver 180, and the reception controller 190 in Fig. 1, respectively. Similar to the source device 610, the destination device 660 may also include a processor 656 and a memory 658.

The processor 656 can be configured to execute program instructions 661 stored in the memory 658 to perform various functions, such as the reception and decoding functions illustrated with reference to Figs. 1-5B. The processor 656 can include a single or multiple processing cores. In some examples, the hybrid decoder 670, the transceiver 680, and/or the reception controller 690 may be implemented by hardware components, the processor 656 executing the program instructions 661, or a combination thereof. It should be understood that the processor 656 can also execute program instructions 661 to perform other functions for the destination device 660 that are not described in the present disclosure.

The memory 658 can be used to store the program instructions 661 and information such an incoming message 662, a parity code 664, a reconstructed message 666, other data 667, and/or intermediate data. In some examples, the memory 658 includes a non-transitory computer readable medium, such as a semiconductor or solid-state memory, a random access memory (RAM), a read-only memory (ROM), a hard disk, an optical disk, or other suitable storage medium. In some embodiments, the memory 658 includes a combination of two or more of the non-transitory computer readable mediums listed above.

Of course, in some examples, an electronic device may be configured to function as both the source device 110 or 610 and the destination device 160 or 660. For example, the source device 610 may be further configured to function as the destination device 660. In such scenario, the processor 652 may be used as the processor 656; the memory 654 may be used as the memory 658; and the transceiver 630 may be used as the transceiver 680. Also, the hybrid decoder 670 and the reception controller 690 may be implemented in the source device by hardware components, the processor 652 executing the program instructions 611 or 661, or a combination thereof.

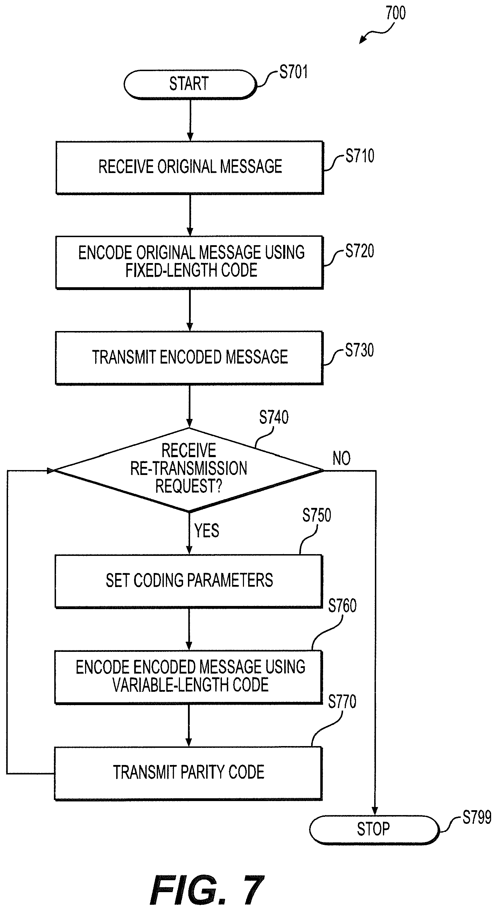

Fig. 7 shows a flow chart outlining an exemplary process 700 for encoding and transmitting messages using a coded-combining method according to an embodiment of the disclosure. In some examples, the process 700 corresponds to the operations illustrated with reference to Figs. 1-3B. It is understood that additional operations may be performed before, during, and/or after the process 700 depicted in Fig. 7. The process 700 starts at S701 and proceeds to S710.

At S710, an original message to be encoded for transmission is received. At S720, the original message is encoded using a fixed-length code. For example, the first encoder 122 of the hybrid encoder 120 receives the original message 112 and generates an encoded message 114 by encoding the original message 112 using a fixed-length code that has a fixed code length and/or a fixed code rate. In some examples, the fixed-length code may use a low-density parity-check (LDPC) code, a polar code, a Hamming code, a Reed-Solomon code, or a Hadamard code.

At S730, the encoded message is transmitted to a destination device during a first transmission. For example, the transceiver 130 may receive the encoded message 114 from the first encoder 122 directly or through the second encoder 124 of the hybrid encoder 120 and transmit the encoded message 114 to the destination device 160 via the communication channel 150.

At S740, whether a re-transmission request from the destination device is received is determined. In some examples, it may be determined that the re-transmission request has been received when the re-transmission request is received within a predetermined period of time after transmitting the encoded message at S730. Otherwise, it may be determined that the re-transmission has not been received. When it is determined that the re-transmission request has been received, the process proceeds to S750. When it is determined that the re-transmission request has not been received, the process thus proceeds to S799.

In some examples, S740 may be performed by the transmission controller 140 together with the transceiver 130.

At S750, coding parameters for a second encoder is set. The second encoder may be used to generate a parity code by encoding the encoded message from S720 using a variable-length code. In some examples, every time a re-transmission request corresponding to transmitting the same original message is received, the coding parameters may be set to correspond to a lower code rate or a longer code length. In some examples, the variable-length code may correspond to a convolutional code based method, such as a convolutional code or a turbo code.

At S760, a parity code is generated by encoding the encoded message from S720. In some examples, the second encoder generates the parity code using the variable-length code with the coding parameters set in S760. For example, the second encoder 124 can generate the parity code 116 by encoding the encoded message 114. In some examples, the parity code may be a first parity code (e.g., non-interleaved parity code) or a punctuated first parity code of turbo coding.

At S770, the parity code generated at S760 is transmitted to the destination device. For example, the transceiver 130 may transmit the parity code 116 to the destination device 160 in response to the re-transmission request therefrom.

After S770, the process 700 proceeds to S740 in order to determine whether another re-transmission requested is received when the transmission of the parity code is insufficient for extracting a corresponding original message.

Finally, at S799, the transmission of the original message, either based on the encoded message and/or one or more additional parity codes, is deemed successful, and the process for transmitting the original message terminates.

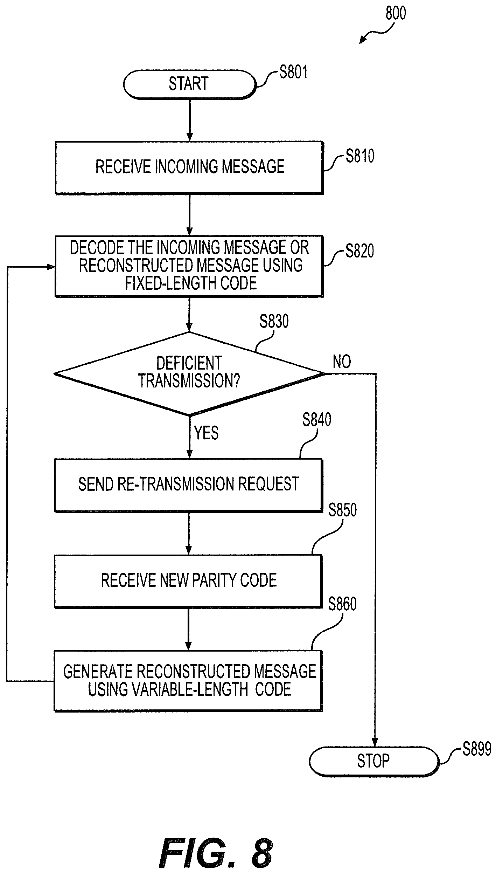

Fig. 8 shows a flow chart outlining an exemplary process 800 for receiving and decoding messages using a coded-combining method according to an embodiment of the disclosure. In some examples, the process 800 corresponds to the operations illustrated with reference to Figs. 1-3B. It is understood that additional operations may be performed before, during, and/or after the process 800 depicted in Fig. 8. The process 800 starts at S801 and proceeds to S810.

At S810, an incoming message is received. At S820, the incoming message is decoded using a fixed-length code. For example, the decoder 172 of the hybrid decoder 170 receives the incoming message 162 directly from the transceiver 180 or through the mixer 174 and generates a decoded message 118 by decoding the incoming message 162 using a fixed-length code that has a fixed code length and/or a fixed code rate. In some examples, the fixed-length code may use a low-density parity-check (LDPC) code, a polar code, a Hamming code, a Reed-Solomon code, or a Hadamard code.

At S830, whether the transmission of the incoming message is insufficient for extracting a corresponding original message is determined. In some examples, when the incoming message cannot be decoded or the decoded message includes more than a predetermined number of errors, the transmission of the incoming message may be determined as insufficient for extracting the corresponding original message. When it is determined that the transmission is insufficient for extracting the original message, the process proceeds to S840; otherwise, the process may proceed to S899. At S840, a re-transmission request is transmitted to the source device. In some examples, S830 and S840 may be performed by the transmission reception 190 together with the transceiver 180.

At S850, a new parity code that is transmitted by the source device in response to the re-transmission request is received. At S860, a reconstructed message is generated based on the incoming message from S810 and the parity code from S850. For example, the mixer 174 may receive the incoming message 162 and the parity code 164 from the transceiver 180 and generate the reconstructed message 166 by at least partially decoding the incoming message 162 and the parity code 164 using a variable-length code. In some examples, the variable-length code may correspond to a convolutional code based method, such as a convolutional code or a turbo code.

After S860, the process 800 proceeds to S820 in order to generate an updated decoded message using the newly generated reconstructed message parity code from S860.

Finally, at S899, the reception and decoding of the incoming message is deemed successful, and the process terminates.

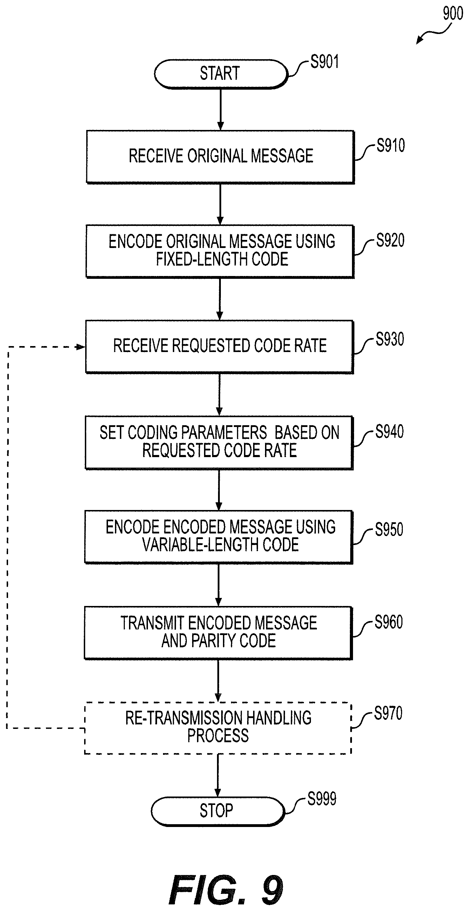

Fig. 9 shows a flow chart outlining an exemplary process 900 for encoding and transmitting messages using a hybrid-coding method according to an embodiment of the disclosure. In some examples, the process 900 corresponds to the operations illustrated with reference to Figs. 1 and 4A-5B. It is understood that additional operations may be performed before, during, and/or after the process 900 depicted in Fig. 9. The process 900 starts at S901 and proceeds to S910.

At S910, an original message to be encoded for transmission is received. At S920, the original message is encoded using a fixed-length code. For example, the first encoder 122 of the hybrid encoder 120 receives the original message 112 and generates an encoded message 114 by encoding the original message 112 using a fixed-length code that has a fixed code length and/or a fixed code rate. In some examples, the fixed-length code may use a low-density parity-check (LDPC) code, a polar code, a Hamming code, a Reed-Solomon code, or a Hadamard code.

At S930, a requested code rate for configuring a second encoder is received. The second encoder may be used to generate a parity code by encoding the encoded message from S920 using a variable-length code. In some examples, the variable-length code may correspond to a convolutional code based method, such as a convolutional code or a turbo code. For example, the transmission controller may receive the requested code rate 142 from other components of the source device 110 or from the destination device 160.

At S940, coding parameters for the second encoder is set based on the requested code rate. At S950, a parity code is generated by encoding the encoded message from S920 based on the set coding parameters. In some examples, the second encoder generates the parity code using the variable-length code with the coding parameters set in S940. For example, the second encoder 124 can generate the parity code 116 by encoding the encoded message 114.

At S960, the encoded message and the parity code are transmitted to a destination device. For example, the transceiver 130 may receive the encoded message 114 from the first encoder 122 directly or through the second encoder 124, as well as the parity code 116 from the second encoder 124, and transmit the encoded message 114 together with the parity code 116 to the destination device 160 via the communication channel 150.

At S970, a re-transmission handling process may be performed in case the transmission of the encoded message from S920 together with the parity code from S950 is insufficient for extracting the original message. In some examples, S970 may include receiving a re-transmission request with a requested code rate from the destination device, and the process may proceeds to S930. In some examples, S970 may include receiving a re-transmission request for additional parity node and may including a process similar to S740 through S770 in Fig. 7.

After S960 or S970, the process proceeds to S999 and terminates.

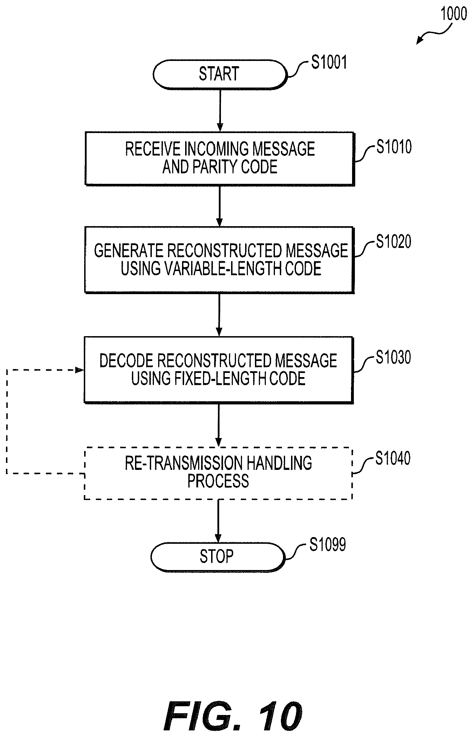

Fig. 10 shows a flow chart outlining an exemplary process 1000 for receiving and decoding messages using a hybrid-coding method according to an embodiment of the disclosure. In some examples, the process 1000 corresponds to the operations illustrated with reference to Figs. 1 and 4A-5B. It is understood that additional operations may be performed before, during, and/or after the process 1000 depicted in Fig. 10. The process 1000 starts at S1001 and proceeds to S1010.

At S1010, an incoming message and a corresponding parity code is received. At S1020, a reconstructed message is generated based on the incoming message and the parity code. For example, the mixer 174 may receive the incoming message 162 and the parity code 164 from the transceiver 180 and generate the reconstructed message 166 by at least partially decoding the incoming message 162 and the parity code 164 using a variable-length code. In some examples, the variable-length code may correspond to a convolutional code based method, such as a convolutional code or a turbo code.

At S1030, the reconstructed message is decoded using a fixed-length code. For example, the decoder 172 of the hybrid decoder 170 receives the reconstructed message 166 from the mixer 174 and generates a decoded message 118 by decoding the reconstructed message 166 using a fixed-length code that has a fixed code length and/or a fixed code rate. In some examples, the fixed-length code may use a low-density parity-check (LDPC) code, a polar code, a Hamming code, a Reed-Solomon code, or a Hadamard code.

At S 1040, a re-transmission handling process may be performed in case the transmission of the incoming message together with the parity code from S 1010 is insufficient for extracting a corresponding original message. In some examples, S1040 may include transmitting a re-transmission request with a requested code rate to the source device, and the process may proceeds to S1010. In some examples, S1040 may include transmitting a re-transmission request for additional parity node and may include a process similar to S830 through S860 in Fig. 8.

After S 1030 or S 1040, the process proceeds to S 1099 and terminates.

While aspects of the present disclosure have been described in conjunction with the specific embodiments thereof that are proposed as examples, alternatives, modifications, and variations to the examples may be made. Accordingly, embodiments as set forth herein are intended to be illustrative and not limiting. There are changes that may be made without departing from the scope of the claims set forth below.

## Claims

1. A source device, comprising:
a first encoder configured to generate an encoded message by encoding an original message using a fixed-length code that has a fixed code rate;
a second encoder configured to generate a parity code by encoding the encoded message using a variable-length code that has an adjustable code rate; and
a transceiver configured to:
transmit the encoded message during a first transmission;
receive a re-transmission request indicating that the first transmission is insufficient for extracting the original message; and
transmit the parity code during a second transmission in response to receiving the re-transmission request.

2. The source device according to claim 1, wherein the transceiver is configured to:
transmit the encoded message without transmitting the parity code during the first transmission; and
transmit the parity code without transmitting the encoded message during the second transmission.

3. The source device according to claim 1 or claim 2, wherein
the second encoder is further configured to generate a second parity code by encoding the encoded message using the variable-length code, and
the transceiver is further configured to:
receive a second re-transmission request indicating that the first and second transmissions are insufficient for extracting the original message; and
transmit the second parity code during a third transmission in response to receiving the second re-transmission request.

4. The source device according to claim 3, wherein the parity code and the second parity code correspond to different code rates or different parity punctuation settings.

5. The source device according to any preceding claim, wherein
the fixed-length code uses a low-density parity-check (LDPC) code, a polar code, a Hamming code, a Reed-Solomon code, or a Hadamard code; and
the variable-length code uses a convolutional code or a turbo code.

6. A destination device, comprising:
a mixer configured to generate a reconstructed message by decoding an incoming message and a parity code using a variable-length code that has an adjustable code rate;
a decoder configured to:
decode the incoming message using a fixed-length code that has a fixed code rate; and
decode the reconstructed message using the fixed-length code; and
a transceiver configured to:
receive the incoming message during a first transmission;
transmit a first re-transmission request indicating that the first transmission is insufficient for extracting an original message; and
receive the parity code that is transmitted during a second transmission in response to the first re-transmission request.

7. The destination device according to claim 6, wherein
the transceiver is further configured to:
transmit a second re-transmission request indicating that the first and second transmissions are insufficient for extracting the original message; and
receive a second parity code that is transmitted in response to the second re-transmission request;
the mixer is further configured to generate a second reconstructed message by decoding at least the incoming message and the second parity code using the variable-length code; and
the decoder is further configured to decode the second reconstructed message using the fixed-length code.

8. The destination device according to claim 7, wherein the mixer is configured to generate the second reconstructed message by decoding the incoming message, the second parity code, and the parity code using the variable-length code.

9. The destination device according to any of claims 6 to 8, wherein
the fixed-length code uses a low-density parity-check (LDPC) code, a polar code, a Hamming code, a Reed-Solomon code, or a Hadamard code; and
the variable-length code uses a convolutional code or a turbo code.

10. The destination device according to any of claims 6 to 9, wherein
the variable-length code includes iterations of plural stages of decoding processes, and
the reconstructed message is generated by performing equal to or less than one full iteration of the plural stages of decoding processes.

11. A source device, comprising:
a first encoder configured to generate an encoded message by encoding an original message using a fixed-length code that has a fixed code rate;
a second encoder configured to generate a parity code by encoding the encoded message using a variable-length code that has an adjustable code rate set based on a requested code rate; and
a transceiver configured to transmit the encoded message together with the parity code.

12. The source device according to claim 11, wherein
the fixed-length code uses a low-density parity-check (LDPC) code, a polar code, a Hamming code, a Reed-Solomon code, or a Hadamard code; and
the variable-length code uses a convolutional code or a turbo code.

13. A destination device, comprising:
a transceiver configured to receive an incoming message together with a parity code;
a mixer configured to generate a reconstructed message by decoding the incoming message and the parity code using a variable-length code that has an adjustable code rate; and
a decoder configured to decode the reconstructed message using a fixed-length code that has a fixed code rate.

14. The destination device according to claim 13, wherein
the fixed-length code uses a low-density parity-check (LDPC) code, a polar code, a Hamming code, a Reed-Solomon code, or a Hadamard code; and
the variable-length code uses a convolutional code or a turbo code.

15. The destination device according to claim 13 or claim 14, wherein
the variable-length code includes iterations of plural stages of decoding processes, and
the reconstructed message is generated by performing equal to or less than one full iteration of the plural stages of decoding processes.
